(19) Europäisches Patentamt
European Patent Office
Office européen des brevets

(11) **EP 2 618 375 A1**

(12) **DEMANDE DE BREVET EUROPEEN**

(43) Date de publication:
**24.07.2013 Bulletin 2013/30**

(21) Numéro de dépôt: **12151753.6**

(22) Date de dépôt: **19.01.2012**

(51) Int Cl.:
*H01L 27/02* *(2006.01)*    *H01L 23/34* *(2006.01)*
*H03B 5/04* *(2006.01)*    *H03L 1/02* *(2006.01)*
*G01R 31/28* *(2006.01)*

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**

(71) Demandeur: **The Swatch Group Research and
Development Ltd.
2074 Marin (CH)**

(72) Inventeurs:
• **Arend, Jean-Luc
2000 Neuchâtel (CH)**
• **Casagrande, Arnaud
2014 Bôle (CH)**

(74) Mandataire: **Ravenel, Thierry Gérard Louis et al
ICB
Ingénieurs Conseils en Brevets SA
Faubourg de l'Hôpital 3
2001 Neuchâtel (CH)**

(54) **Procédé et système de mesure pour la calibration thermique d'un circuit électronique**

(57) Le procédé de mesure permet de calibrer thermiquement un circuit électronique intégré (1). Pour ce faire, le circuit intégré comprend une résistance de chauffage intégrée (2), au moins une jonction bipolaire (3) en tant que capteur de température et un ensemble électronique (4) à calibrer du circuit intégré. Selon le procédé de mesure, une première température est établie dans le circuit intégré par la résistance de chauffage traversée par un premier courant, et mesurée par la jonction bipolaire traversée par un courant continu (Im) d'une source de courant externe (12). Des paramètres électroniques de l'ensemble électronique sont mesurés à la première température stable et mémorisés dans une mémoire. Par la suite, une seconde température supérieure à la première température est établie dans le circuit intégré par la résistance de chauffage (2) traversée par un second courant, et mesurée par la jonction bipolaire (3) traversée par le courant continu (Im). Les paramètres électroniques sont mesurés à la seconde température stable et mémorisés dans la mémoire. Une variation en température des paramètres est déterminée sur la base des paramètres mémorisés afin de calibrer ces paramètres en fonction de paramètres de référence.

Fig. 1

**Description**

L'invention concerne un procédé de mesure pour la calibration thermique d'un circuit électronique intégré. Le circuit électronique intégré comprend au moins un élément de chauffage disposé dans ou sur un substrat semi-conducteur du circuit intégré, au moins un capteur de température disposé dans ou sur le substrat semi-conducteur du circuit intégré, et un ensemble électronique à calibrer du circuit intégré.

L'invention concerne également un système de mesure pour la mise en oeuvre du procédé de mesure pour la calibration thermique d'un circuit électronique.

L'invention concerne également un circuit électronique intégré convenant à la mise en oeuvre du procédé de mesure pour la calibration thermique dudit circuit électronique.

Au terme du procédé de fabrication des circuits électroniques intégrés, il doit être effectué un test électrique de différents paramètres électroniques de chaque circuit intégré. Généralement le test électrique de ces paramètres électroniques est effectué sur chaque plaquette, qui comprend plusieurs circuits intégrés réalisés dans un substrat semi-conducteur. Dans le cas où il doit encore être effectué un test en température d'un circuit intégré sur plaquette ou enfermé dans un boîtier plastique sous forme de module électronique, il est nécessaire de placer un ou plusieurs circuits intégrés dans une enceinte thermique. Cette enceinte thermique est encombrante et le temps pris pour stabiliser la température de mesure du ou des circuits intégrés en phase de test est relativement grand. Le test en température de plusieurs circuits intégrés dans une enceinte thermique est de ce fait long à mettre en oeuvre. Cela rend ce test des paramètres électroniques en température relativement coûteux et difficile à réaliser pour permettre de calibrer en température rapidement et précisément chaque circuit intégré, ce qui constitue un inconvénient.

Comme différents paramètres électroniques varient généralement de manière non linéaire avec la température, il peut être prévu pour faciliter la mesure précise de la température du circuit intégré en phase de test d'utiliser la méthode de mesure décrite dans le brevet US 5,195,827. Dans ce brevet, il est utilisé, dans le circuit intégré, soit une diode bipolaire, soit de préférence un transistor bipolaire, qui est traversé successivement par des courants continus de valeur différente. Des mesures de la différence de la tension de jonction ou de la tension base-émetteur suite à au moins deux courants traversant la diode ou le transistor sont effectuées. Sur la base d'une ou plusieurs mesures de l'écart de la tension de jonction, il est possible de déterminer exactement la température localement du circuit intégré à proximité de la diode ou du transistor de mesure. Plus de deux courants pour traverser successivement par exemple le transistor bipolaire peuvent aussi être prévus notamment pour pouvoir éliminer les effets des résistances parasites liées au transistor de mesure.

Cependant rien n'est décrit concernant l'utilisation d'une telle mesure précise de la température du circuit intégré en phase de test à plusieurs niveaux de température. Le circuit intégré décrit n'est également pas adapté pour pouvoir effectuer une calibration rapide de certains paramètres électroniques du circuit intégré électronique par un test en température, ce qui peut constituer un inconvénient d'une telle solution. Il doit encore être utilisé un ampèremètre pour mesurer précisément la valeur de chaque source de courant connectée successivement au transistor bipolaire de mesure ou à la diode bipolaire pour pouvoir déterminer la température, ce qui complique la mesure de température.

Dans le brevet US 4,284,872, il est décrit un appareil pour compenser l'écart thermique d'un circuit sensible à la température dans un circuit intégré. Pour ce faire, il est prévu d'insérer directement dans le circuit intégré un élément de chauffage local. Cet élément de chauffage local est de préférence constitué par une résistance diffusée ou implantée, qui entoure le circuit sensible à la température. La température du circuit intégré peut ainsi être augmentée rapidement par ladite résistance de chauffage traversée par un courant adapté. Le circuit intégré comprend également une résistance de compensation à film fin dans le circuit sensible à la température. Cette résistance de compensation à film fin affecte ou détermine le degré de sensibilité en température du circuit sensible à la température. Quand la température du circuit sensible à la température augmente, l'appareil de test est utilisé pour mesurer un paramètre sensible à la température du circuit sensible à la température. Des signaux de commande sont produits en réponse au test pour compenser de manière adéquate l'écart thermique du circuit sensible à la température. Les signaux de commande sont utilisés pour commander les opérations d'un laser, qui trime précisément la résistance de compensation à film fin par la quantité désirée.

Cependant rien n'est prévu dans ce brevet US 4,284,872 concernant un test pour pouvoir calibrer en température différents paramètres électriques suite à une mesure à plusieurs niveaux de température du circuit intégré, ce qui constitue un inconvénient. Il n'est également pas spécifié précisément une manière de mesurer précisément la température localement dans le circuit intégré pour pouvoir effectuer un calibrage en température du circuit intégré, ce qui constitue un autre inconvénient.

L'invention a donc pour but de fournir un procédé de mesure pour la calibration thermique d'un circuit électronique intégré rapide et précise, qui est susceptible de pallier aux inconvénients de l'état de la technique susmentionné.

A cet effet, l'invention concerne un procédé de mesure pour la calibration thermique d'un circuit électronique, qui comprend les caractéristiques mentionnées dans la revendication indépendante 1.

Des étapes particulières du procédé de mesure sont définies dans les revendications dépendantes 2 à 9.

Un avantage du procédé de mesure pour la calibration thermique d'un circuit électronique selon l'invention, réside dans le fait qu'il permet d'effectuer des mesures de différents paramètres électroniques à différentes températures stables très rapidement sans avoir besoin d'utiliser une enceinte thermique. L'élément de chauffage intégré dans le circuit électronique permet d'augmenter généralement la température localement du circuit électronique rapidement pour permettre, une fois la température stabilisée, d'effectuer des mesures de différents paramètres électroniques. Un capteur de température sous la forme d'une jonction bipolaire permet de déterminer la température localement et à proximité d'une partie électronique à calibrer du circuit électronique. Plusieurs mesures à des températures différentes stables, peuvent ainsi être effectuées et mémorisées. Sur la base des résultats des mesures effectuées, cela permet de calibrer un ou plusieurs paramètres électroniques, tels qu'une fréquence d'un oscillateur, qui varie avec la température. Cela permet également de pouvoir calibrer la fréquence exacte d'un oscillateur du type LC pour réaliser une base de temps précise d'une montre.

Avantageusement, le capteur de température est de préférence une jonction bipolaire, telle qu'une diode bipolaire ou un transistor monté en diode. L'élément de chauffage est de préférence une résistance de manière à pouvoir être traversée par un courant déterminé selon une consigne de mesure fournie, afin de chauffer localement le circuit électronique à une température stable de mesure. Le courant déterminé à fournir à la résistance de chauffage est asservi en fonction d'une mesure d'une tension de jonction de la diode traversée par au moins un courant constant, qui peut être comparée à la tension de consigne pour avoir la température souhaitée.

A cet effet, l'invention concerne également un système pour la mise en oeuvre du procédé de mesure pour la calibration thermique d'un circuit électronique, qui comprend les caractéristiques définies dans la revendication indépendante 10.

Des formes particulières d'exécution du système sont définies dans les revendications dépendantes 11 à 15.

A cet effet, l'invention concerne également un circuit électronique intégré dans un substrat semi-conducteur, qui est prévu pour la mise en oeuvre du procédé de mesure, et qui comprend les caractéristiques définies dans la revendication indépendante 16.

Des formes particulières d'exécution du circuit électronique sont définies dans les revendications dépendantes 17 et 18.

Les buts, avantages et caractéristiques du procédé et du système de mesure pour la calibration thermique d'un circuit électronique intégré, apparaîtront mieux dans la description suivante sur la base de formes d'exécution non limitatives illustrées par les dessins sur lesquels :

la figure 1 représente de manière simplifiée une première forme d'exécution d'un système de mesure pour la calibration thermique de différents paramètres électroniques d'un circuit électronique intégré selon l'invention,

la figure 2 représente de manière simplifiée une seconde forme d'exécution d'un système de mesure pour la calibration thermique de différents paramètres électroniques d'un circuit électronique intégré selon l'invention, et

la figure 3 représente un graphique de la tension de jonction d'une diode bipolaire traversée par un courant constant dans le temps et à différents niveaux de température du procédé de mesure selon l'invention.

Dans la description suivante, tous les composants électroniques du système de mesure et du circuit électronique intégré pour le système de mesure, qui sont bien connus d'un homme du métier dans ce domaine technique, ne sont décrits que de manière simplifiée. Le circuit électronique intégré peut être testé soit sur une plaquette au terme du procédé de fabrication, soit une fois enfermé dans un boîtier plastique en tant que module électronique.

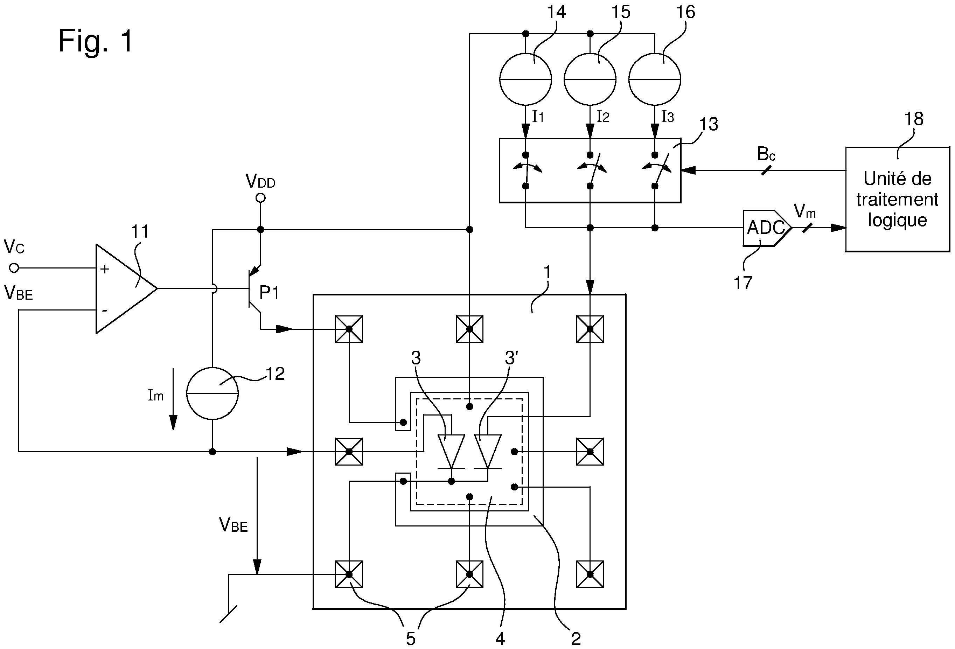

La figure 1 représente de manière simplifiée une première forme d'exécution du système de mesure avec le circuit électronique 1. Ce circuit électronique est intégré dans un substrat semi-conducteur traditionnel, tel qu'un substrat en silicium ou en arséniure de gallium ou en germanium, selon un procédé de fabrication en technologie CMOS.

Le circuit électronique 1 comprend un élément de chauffage 2, qui est de préférence constitué d'une résistance diffusée ou implantée ou d'une résistance en poly-silicium, si le substrat semi-conducteur utilisé est un substrat en silicium. Cet élément de chauffage 2 sous forme de résistance entoure un ensemble électronique 4 du circuit intégré, dont des paramètres électroniques sont susceptibles de varier avec la température. Le circuit électronique 1 comprend encore au moins un capteur de température 3, 3', qui est constitué par une jonction bipolaire, telle qu'une diode bipolaire ou un transistor bipolaire NPN ou PNP monté en diode.

Dans cette première forme d'exécution, le circuit électronique 1 comprend deux jonctions bipolaires 3 et 3' pour la mesure de température et l'adaptation du courant à travers l'élément de chauffage 2. Ces jonctions bipolaires 3, 3' peuvent faire partie de l'ensemble électronique 4, dont certains paramètres électroniques doivent être calibrés en température comme expliqué ci-après. Plusieurs autres capteurs de température peuvent aussi être prévus dans le circuit intégré 1 à différents emplacements du circuit intégré.

L'ensemble électronique 4 peut comprendre un oscillateur, dont la fréquence change en fonction de la température. Cet oscillateur peut également servir de capteur de température, qu'il faut calibrer. L'oscillateur peut aussi être un oscillateur du type LC, qu'il faut calibrer selon le procédé de mesure de la présente invention pour connaître la fréquence exacte en fonction de la température. Cet oscillateur LC peut être utilisé pour réaliser une base de temps précise pour une montre.

Plusieurs plages métalliques de contact 5 sont également prévues sur le circuit électronique 1 de manière à relier la résistance de chauffage 2, les jonctions bipolaires 3, 3' et différentes parties électroniques de l'ensemble électronique 4. Ces plages de contact 5 permettent d'une part d'opérer un test électrique dans un appareil de test des fonctionnalités du circuit électronique 1, et d'autre part de relier vers l'extérieur les différents composants électroniques du circuit électronique 1. Après la phase de calibration en température de l'ensemble électronique 4, il peut être prévu de déconnecter la ou les jonctions bipolaires 3, 3'. Ceci permet de pouvoir utiliser les plages de contact 5 reliant précédemment les jonctions pour d'autres éléments électroniques du circuit électronique, afin de réduire la taille du circuit intégré électronique.

Généralement au terme du procédé de fabrication, chaque plaquette de circuits intégrés est disposée dans l'appareil de test pour effectuer tous les tests de fonctionnalités du circuit électronique dans des limites spécifiées à une température bien définie. Un test individuel des fonctionnalités de chaque circuit électronique peut également être effectué une fois que la plaquette est sciée et chaque circuit électronique enfermé dans un boîtier plastique sous forme de module électronique. Ce test du circuit électronique encapsulé peut être nécessaire pour tenir compte de toute contrainte mécanique suite à l'encapsulation. Pour pouvoir calibrer certains paramètres électroniques notamment de l'ensemble électronique 4 de chaque circuit électronique, il doit encore être effectué un test à différentes températures stables comme expliqué ci-après.

Le système de mesure avec le circuit électronique 1 comprend encore au moins une source de courant externe d'adaptation 12. Cette source de courant d'adaptation 12 est par exemple reliée entre une borne de potentiel haut $V_{DD}$ d'une source de tension d'alimentation non représentée, et une borne de la première jonction bipolaire 3 par l'intermédiaire d'une plage de contact 5. L'autre borne de la jonction bipolaire 3 est reliée à une autre plage de contact 5, afin d'être reliée par exemple à une borne de potentiel bas de la source de tension d'alimentation. Ainsi la source de courant d'adaptation 12 fournit un courant continu bien déterminé Im à la première jonction bipolaire 3, afin de pouvoir mesurer par l'intermédiaire des plages de contact 5 reliées à la première jonction bipolaire, une tension de jonction $V_{BE}$. Dans cette version analogique du système de mesure, cette tension de jonction de la première jonction 3, qui varie généralement de -2 mV/°K, est utilisée pour réguler le courant fourni à travers l'élément de chauffage, c'est-à-dire à travers la résistance de chauffage 2. Il n'est par contre pas possible d'effectuer une mesure précise de température uniquement par une seule mesure de la tension de jonction $V_{BE}$.

Dans cette première forme d'exécution du système de mesure, il est encore prévu une seconde jonction bipolaire 3' pour la mesure de température. Cette seconde jonction 3' est reliée par une de ses bornes à une plage de contact 5 différente de celle de la première jonction 3. Par cette plage de contact 5, la seconde jonction 3' peut recevoir successivement deux courants I1, I2, et de préférence trois courants I1, I2, I3 provenant d'une première source de courant 14, d'une seconde source de courant 15 et d'une troisième source de courant 16. Ces trois sources de courant sont par exemple reliées à une borne de potentiel haut $V_{DD}$ de la source de tension d'alimentation non représentée. Un élément de commutation 13 est encore prévu entre les première, seconde et troisième sources de courant 14, 15, 16 et la plage de contact 5 reliée à une des bornes de la seconde jonction 3'. L'autre borne de la seconde jonction 3' est reliée par l'intermédiaire d'une plage de contact 5 à la borne de potentiel bas de la source de tension d'alimentation, tout comme pour la première jonction bipolaire 3.

L'élément de commutation 13, qui peut comprendre des interrupteurs sous forme de transistors MOS, est contrôlé par un signal binaire de commande Bc. Ce signal binaire Bc est fourni par une unité de traitement logique 18 pour fournir successivement le premier courant continu I1, le second courant continu I2 et éventuellement le troisième courant continu I3, qui sont de valeur différente, à la jonction bipolaire 3'. La première tension de jonction $V_{BE}$ relative au premier courant I1 est convertie par un convertisseur analogique-numérique ADC 17, afin de fournir une première tension convertie Vm à traiter dans l'unité de traitement logique 18. Il en est de même successivement pour la seconde tension de jonction relative au second courant I2, et éventuellement pour la troisième tension de jonction relative au troisième courant I3. Ces seconde et troisième tensions de jonction sont converties en des seconde et troisième tensions converties Vm par le convertisseur 17 pour être traitées dans l'unité de traitement logique 18. Un ou deux écarts $\Delta V_{BE}$ de tension de jonction peuvent être déterminés dans l'unité de traitement logique sur la base des deux ou trois courants successifs fournis à la seconde jonction bipolaire 3'.

Par l'utilisation des trois courants I1, I2, I3 fournis à la seconde jonction bipolaire, cela permet de déterminer précisément une température locale du circuit intégré tout en tenant compte des éléments parasites liés à la seconde jonction bipolaire 3', tels que des résistances parasites. Cette température mesurée est pratiquement indépendante des variations des paramètres technologiques du procédé de fabrication d'une plaquette de circuits intégrés à une autre plaquette de circuits intégrés. Cette température mesurée est également pratiquement indépendante des valeurs des courants traversant la jonction bipolaire. L'exactitude de la température mesurée par ce procédé peut être de l'ordre d'environ ±0.1 °C.

Dans le cas d'une seconde jonction bipolaire 3' sous la forme d'un transistor PNP ou NPN monté en diode par exemple, la mesure exacte de la température peut être réalisée par deux courants continus de collecteurs I1 et I2 traversant successivement le transistor monté en diode. De préférence, trois courants I1, I2, I3 traversant successivement la seconde jonction sont nécessaires pour mesurer précisément la température. Pour deux courants successifs traversant la seconde jonction 3', la différence de tension de jonction, qui est la tension base-émetteur $V_{BE}$ est donnée par la formule suivante :

$$\Delta V_{BE} = V_{BE2} - V_{BE1} = (k \cdot T / q) \cdot \ln(I2/I1)$$

où k est la constante de Boltzmann, q est la charge élémentaire et T est la température en Kelvin. Il peut encore être déterminé un second écart de tension de jonction avec le second courant I2 et le troisième courant I3, ce qui permet de s'affranchir de tout élément parasite lié à la seconde jonction bipolaire 3', comme également mentionné dans le brevet US 5,195,827.

Le système de mesure comprend encore un comparateur 11 pour comparer la tension de jonction $V_{BE}$ de la première jonction 3 avec une tension de consigne Vc. La sortie du comparateur 11 est reliée à la base d'un transistor PNP P1, dont l'émetteur est relié à la borne de potentiel haut $V_{DD}$ de la source de tension d'alimentation. Le collecteur du transistor PNP P1 est relié à une extrémité de la résistance de chauffage 2 par l'intermédiaire d'une plage de contact 5. L'autre extrémité de la résistance de chauffage 2 est reliée à la borne de potentiel bas de la source de tension d'alimentation par l'intermédiaire d'une autre plage de contact 5.

En fonction de la valeur de consigne Vc fournie par l'unité de traitement logique, un courant est fourni par le transistor PNP P1 pour traverser la résistance de chauffage 2, afin de la faire chauffer. Ce courant peut être de l'ordre de 300 mA. Cette résistance 2 traversée par le courant du transistor PNP P1 dissipe de la chaleur donnée par l'équation de puissance $P = R \cdot I^2$. Pour établir trois températures différentes, il peut être prévu trois valeurs de consigne pour avoir trois courants différents traversant la résistance de chauffage 2. En fonction de l'élévation de la température locale dans le circuit intégré, la valeur de la tension de jonction $V_{BE}$ de la première jonction 3 traversée par le courant bien déterminé Im, va diminuer. Comme cette tension de jonction est comparée à la valeur de consigne, qui est une tension de consigne Vc, cela a pour effet de plus ou moins augmenter le courant traversant la résistance de chauffage 2 dans une boucle de d'asservissement de courant. Le courant devient stable dès que la tension de jonction $V_{BE}$ est proche de la tension de consigne Vc. La température déterminée par la tension de consigne va être bien déterminée et rester stable pour pouvoir effectuer les tests de paramètres électroniques à cette température.

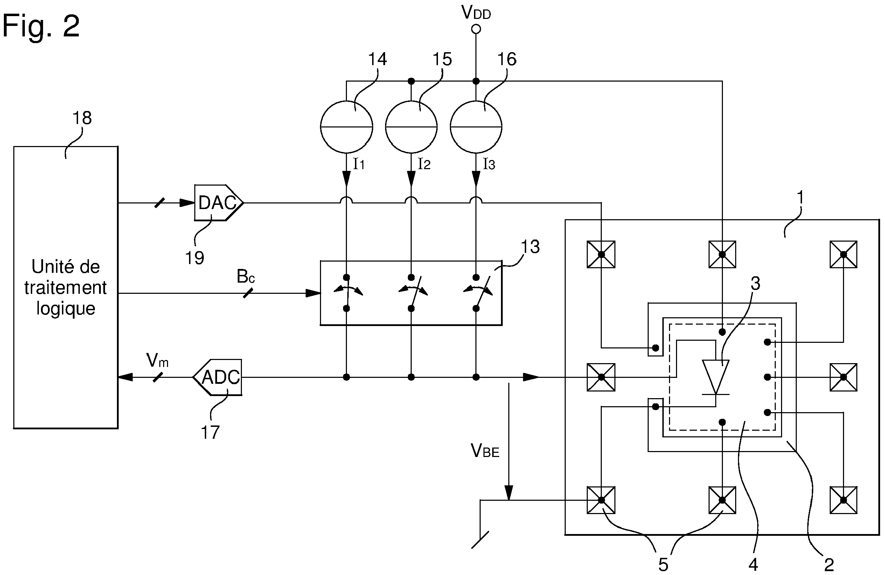

Il est à noter qu'en lieu et place d'une boucle d'asservissement pour un réglage du courant de manière analogique, il peut aussi être prévu d'effectuer un tel réglage du courant dans une boucle de réglage numérique comme expliqué ci-dessous en référence à la figure 2. Sur cette figure 2, il est représenté une seconde forme d'exécution du système de mesure avec le circuit électronique 1. Il est à noter que tous les mêmes éléments du système préalablement décrits en référence à la figure 1, portent des signes de référence identiques. Ainsi par simplification, il ne sera pas répété la description détaillée de chacun de ces éléments pour cette figure 2.

Par le système de mesure de la figure 2, le circuit électronique 1 ne comprend qu'une seule jonction bipolaire 3 pour la mesure de température et pour permettre l'adaptation numériquement du courant traversant l'élément de chauffage 2, tel qu'une résistance de chauffage. Pour la mesure de température, la première jonction bipolaire 3 est prévue pour recevoir successivement deux courants continus I1 et I2, et de préférence trois courants continus I1, I2, I3 de valeur différente. Ces trois courants I1, I2, I3 proviennent respectivement des première, seconde et troisième sources de courant 14, 15, 16. Une mesure successive des première, seconde et troisième tensions de jonction $V_{BE}$ de la première jonction 3, traversée successivement par les trois courants I1, I2 et I3, est effectuée par l'intermédiaire des plages de contact 5 reliées à la première jonction bipolaire 3.

La sélection des trois sources de courant 14, 15, 16 pour la fourniture successive des trois courants I1, I2 et I3 est opérée par l'intermédiaire d'un élément de commutation 13. Cet élément de commutation est commandé par un signal binaire de commande Bc fourni par une unité de traitement logique 18. Les première, seconde et troisième tensions de jonction mesurées sur la base des trois courants continus I1, I2, I3 traversant successivement la première jonction 3, sont converties par un convertisseur analogique-numérique ADC 17 pour fournir des première, seconde et troisième tensions converties Vm à l'unité de traitement logique.

L'unité de traitement logique 18 permet donc de réguler le courant de chauffage à fournir à la résistance de chauffage 2 et de mesurer la valeur absolue exacte de la température avec la même première jonction 3. En fonction de la mesure des trois tensions de jonction converties par le convertisseur analogique-numérique 17, il est possible d'effectuer un traitement numérique efficace dans ladite unité. Deux écarts de tension de jonction peuvent ainsi être déterminés dans l'unité de traitement logique 18 pour connaître exactement la température locale dans le circuit électronique intégré.

Suite à ce traitement numérique, l'unité de traitement logique 18 fournit encore un signal numérique de commande à un convertisseur numérique-analogique 19, qui convertit ce signal numérique pour fournir un courant déterminé à la résistance de chauffage 2 par l'intermédiaire des plages de contact 5 du circuit intégré. L'adaptation de ce courant est entièrement traitée numériquement dans l'unité de traitement logique 18 sur la base d'une valeur de consigne. Cette valeur de consigne peut être un courant ou une tension de manière à fournir un signal numérique de commande, afin d'atteindre la température souhaitée. L'adaptation du courant peut aussi tenir compte de la mesure de la ou des tensions de jonction de la jonction bipolaire 3, qui ont été converties numériquement.

Le procédé de mesure pour la calibration du circuit électronique 1 va maintenant être décrit plus en détail. Il peut être prévu d'effectuer un test de différentes parties électroniques du circuit intégré pour détecter tout circuit en dehors de limites prédéfinies à une température définie. De plus, il doit encore être opéré une calibration d'un ou plusieurs circuits électroniques intégrés ou tous les circuits électroniques intégrés, qui sont sur une plaquette ou déjà encapsulés sur un banc de test. La calibration d'au moins certaines parties de chaque circuit intégré est opérée sur la base de résultats de certains paramètres à différents paliers de températures stables. Il est donc nécessaire de rapidement et facilement placer une zone du circuit intégré à calibrer à une température stable durant la mesure. Pour ce test en température afin de calibrer certains paramètres électroniques, il peut être effectué le procédé de mesure pour quelques circuits intégrés ou tous les circuits intégrés d'une même plaquette. Tous les autres circuits peuvent, par la suite, être calibrés sur la base des mesures effectuées à différentes températures pour quelques circuits intégrés de la même plaquette. Les circuits intégrés à tester de la même plaquette peuvent être choisis de manière aléatoire, mais en assurant une bonne répartition de circuits à tester sur la plaquette.

Pour le procédé de mesure, il peut être prévu d'effectuer deux points de mesure à deux températures stables différentes pour toute variation linéaire en température de paramètres électroniques du circuit. Cependant, il peut être prévu d'effectuer de préférence au moins trois points de mesure à trois températures stables différentes pour toute variation non linéaire en température de paramètres électroniques du circuit.

Il peut tout d'abord être mesuré que la température du circuit électronique est à une température initiale T0 sur la base de l'écart mesuré de la tension de jonction à deux courants déterminés I1 et I2 traversant successivement la première jonction bipolaire 3 ou la seconde jonction bipolaire 3'. De préférence, il peut être déterminé deux écarts de tension de jonction à trois courants déterminés I1, I2 et I3 pour avoir une mesure précise de la température locale. Cette température initiale T0 peut être la température ambiante. Cependant cette mesure de la température initiale peut également être omise avant d'établir une première température de mesure dans le circuit électronique.

Après la mesure de la température initiale T0, la température locale dans le circuit électronique est établie de manière constante par réglage à une première température T1. Cette première température T1 est normalement supérieure à la température initiale T0. Pour ce faire, la boucle d'asservissement en courant envoie un premier courant réglé à travers l'élément de chauffage, qui est la résistance de chauffage 2 intégrée dans le circuit électronique 1. Un nouvel écart de tension de jonction est mesuré sur la base des deux courants déterminés I1 et I2 injectés dans la première jonction bipolaire 3 ou la seconde jonction bipolaire 3', une fois que la première température T1 est stable. De préférence, il peut être déterminé deux écarts de tension de jonction à trois courants déterminés I1, I2 et I3 pour avoir une mesure précise de la première température T1. Cela permet de déterminer la température locale dans le circuit intégré. A cette première température T1, certains paramètres électroniques susceptibles de varier avec la température de l'ensemble électronique 4 sont mesurés et mémorisés en particulier dans une mémoire du circuit intégré et/ou dans une mémoire externe.

La température du circuit électronique 1 à calibrer est établie de manière constante à une seconde température T2 supérieure à la première température T1. Pour ce faire, la résistance de chauffage 2 est traversée par un second courant adapté dans la boucle d'asservissement de courant. Ce second courant est supérieur au premier courant. L'écart de tension de jonction de la première jonction bipolaire 3 ou de la seconde jonction bipolaire 3', est mesuré sur la base des deux courants déterminés I1 et I2 injectés dans la première jonction bipolaire 3 ou la seconde jonction bipolaire 3', une fois que la seconde température T2 est stable. De préférence, il est déterminé deux écarts de tension de jonction à trois courants déterminés I1, I2 et I3 pour avoir une mesure précise de la seconde température T2. A cette seconde température T2, les mêmes paramètres électroniques de l'ensemble électronique sont mesurés et mémorisés.

Ces deux points de mesure peuvent suffire pour calibrer certains paramètres dont la variation en température est linéaire, mais généralement la plupart des paramètres électroniques mesurés varient de manière non linéaire avec la température. Dans ces conditions, la température du circuit électronique à calibrer est établie de manière constante à une troisième température T3 supérieure à la seconde température T2. Pour ce faire, la résistance de chauffage 2 est traversée par un troisième courant adapté dans la boucle d'asservissement de courant. Ce troisième courant est supérieur au second courant. L'écart de tension de jonction de la première jonction bipolaire 3 ou de la seconde jonction bipolaire 3', est mesuré sur la base des deux courants déterminés I1 et I2 injectés dans la première jonction bipolaire 3 ou la seconde jonction bipolaire 3', une fois que la troisième température T3 est stable. De préférence, il est déterminé deux écarts de tension de jonction à trois courants déterminés I1, I2 et I3 pour avoir une mesure précise de la troisième température T3. A cette troisième température T3, les mêmes paramètres électroniques de l'ensemble électronique 4 sont mesurés et mémorisés.

Les paramètres de l'ensemble électronique 4 à calibrer sont calculés sur la base des trois mesures effectuées aux trois températures. Ces paramètres peuvent être adaptés sur la base de paramètres de référence. Les paramètres adaptés sont stockés dans la mémoire non volatile du circuit intégré. La calibration est ainsi terminée et tous les paramètres adaptés, qui ont été mémorisés dans les circuits électroniques testés peuvent généralement être mémorisés dans les autres circuits électroniques de la même plaquette de circuits intégrés.

Il est à noter que les valeurs des première, seconde et troisième températures de mesure peuvent être différentes d'un circuit électronique en test à un autre circuit électronique, mais leur valeur absolue est connue précisément. Cela permet ainsi de calculer les paramètres de correction de parties de l'ensemble électronique 4. Il peut encore être prévu d'effectuer des mesures à plus de trois températures stables.

Comme susmentionné en phase de test, il est imposé au circuit intégré 1 une série de paliers de températures précises de fonctionnement. Des sauts thermiques sont rapidement effectués par la résistance de chauffage intégrée dans un intervalle temporel, qui peut être de l'ordre de 20 ms ou inférieur en fonction de l'écart d'un palier de température à un autre palier de température. Il peut être très rapidement passé d'une première température à une seconde température, qui peut être supérieure de près de 50°C en 20 ms. Cela permet de facilement et rapidement effectuer une mesure de certains paramètres à une température de palier fixée et stable. Il n'est pas nécessaire pour effectuer ces tests thermiques d'utiliser une enceinte thermique, qui est encombrante et dont le temps de mesure est relativement long. Les contraintes de précision sont déplacées vers l'extérieur.

Généralement les paramètres mémorisés peuvent être les coefficients d'un polynôme d'ordre n. Grâce aux différentes valeurs prélevées pour au moins trois températures différentes de mesure, il est possible de mesurer des paramètres du circuit, tels que la fréquence d'oscillation, une ou plusieurs tensions de parties du circuit, un ou plusieurs courants de parties du circuit. Aux différents paliers thermiques de mesure, par exemple à trois paliers de mesure, il est possible par une interpolation polynomiale par exemple ou une opération pour minimiser l'erreur quadratique des trois points de mesure de s'approcher d'une courbe de variation de référence de tel ou tel paramètre à calibrer. Le comportement thermique peut être stocké dans une mémoire du circuit intégré.

Dans le cas de deux fréquences mesurées dans le circuit intégré, la valeur précise de la température de mesure n'est plus importante. Ce n'est que la variation des trois points de mesure aux deux fréquences, qui est importante pour déterminer la courbe de variation de la fréquence.

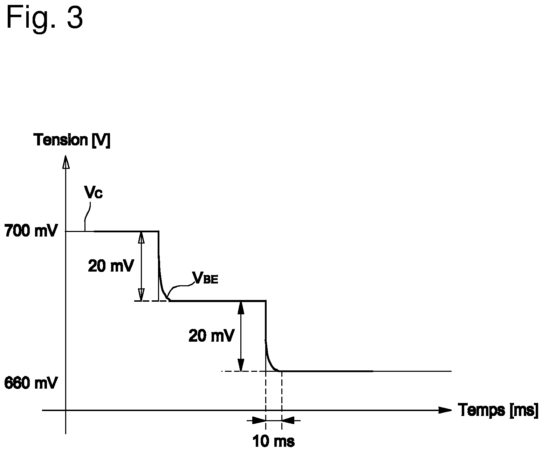

La figure 3 représente à titre illustratif un graphique de la tension de jonction d'une diode bipolaire traversée par un courant constant dans le temps et à différents niveaux de température du procédé de mesure selon l'invention. Sur cette figure 3, il est opéré des sauts en température pour chaque palier de température de 10°C. La tension de jonction $V_{BE}$ peut valoir environ 700 mV à la première température T1 avec une valeur de consigne Vc imposée dans la boucle d'asservissement en courant notamment dans la version analogique du système de mesure.

Comme la tension de diode $V_{BE}$ varie de l'ordre de -2 mV/°C, la tension de jonction diminue de -20 mV pour passer de la première température T1 à la seconde température T2. Le temps de stabilisation de la tension de jonction à la seconde température est d'environ 10 ms. Dès la stabilisation de la température T2, les mesures des différents paramètres peuvent être effectuées à cette seconde température T2 stable. Une nouvelle fois pour passer de la seconde température T2 à la troisième température T3, qui est 10°C supérieure à la seconde température T2, la tension de jonction diminue encore de -20 mV. Il doit encore être attendu un temps de l'ordre de 10 ms pour avoir la tension de jonction établie à la troisième température T3 stable afin d'effectuer les mesures des paramètres électroniques.

Pour le procédé de mesure pour la calibration thermique du circuit électronique, il est toujours effectué une augmentation de la température par la résistance de chauffage 2 pour rapidement mesurer les différents paramètres. Pour pouvoir abaisser la température au lieu de l'augmenter, il faudrait munir le circuit électronique d'un élément du type Pelletier.

Il est encore à noter que dans le cas où il est utilisé un capteur thermique disposé dans un coin du circuit intégré, il peut y avoir un fort gradient thermique de stabilisation en température. Cela est différent pour un capteur thermique placé à proximité de la résistance de chauffage. Plusieurs capteurs thermiques peuvent donc être placés dans le circuit électronique à calibrer pour pouvoir calibrer au mieux différents paramètres électroniques du circuit électronique.

A partir de la description qui vient d'être faite, plusieurs variantes du procédé ou système de mesure pour la calibration thermique d'un circuit électronique peuvent être conçues par l'homme du métier sans sortir du cadre de l'invention définie par les revendications. La jonction bipolaire de mesure de la température peut être une diode ou un transistor NPN monté en diode. La jonction bipolaire peut être reliée entre la borne de potentiel haut de la source de tension d'alimentation et une source de courant reliée à la borne de masse. Le transistor bipolaire de fourniture du courant à la résistance de chauffage peut être un transistor NPN. Chaque capteur de température peut être constitué d'une résistance diffusée ou implantée en étant traversée par un courant déterminé et par une mesure de la tension aux bornes de la résistance.

**Revendications**

1. Procédé de mesure pour la calibration thermique d'un circuit électronique intégré (1), qui comprend au moins un élément de chauffage (2) disposé dans ou sur un substrat semi-conducteur du circuit intégré, au moins un capteur de température (3, 3') disposé dans ou sur le substrat semi-conducteur du circuit intégré, et un ensemble électronique (4) à calibrer du circuit intégré, dont des paramètres électroniques sont susceptibles de varier avec la température, le procédé étant **caractérisé en ce qu'**il comprend les étapes de :

   - régler la température localement dans le circuit intégré (1) au moyen de l'élément de chauffage (2) alimenté électriquement, jusqu'à une première température stable (T1) du circuit intégré, en mesurant la première température au moyen du capteur de température (3, 3'),
   - effectuer des mesures de paramètres électroniques de l'ensemble électronique (4) à la première température stable, et mémoriser les paramètres électroniques à la première température stable (T1),
   - régler la température localement dans le circuit intégré (1) au moyen de l'élément de chauffage (2) alimenté électriquement, jusqu'à une seconde température stable (T2) différente de la première température stable (T1) du circuit intégré, en mesurant la seconde température au moyen du capteur de température (3, 3'),
   - effectuer des mesures des paramètres électroniques de l'ensemble électronique (4) à la seconde température stable, et mémoriser les paramètres électroniques à la seconde température stable (T2),
   - déterminer la variation en température des paramètres électroniques sur la base des paramètres mémorisés à la première température et à la seconde température, afin d'effectuer une calibration de ces paramètres en fonction de paramètres de référence.

2. Procédé de mesure selon la revendication 1, **caractérisé en ce qu'**il comprend une étape initiale de mesure d'une température initiale (T0) du circuit intégré (1) au moyen du capteur de température (3, 3') alimenté électriquement, avant d'établir localement la première température dans le circuit électronique au moyen de l'élément de chauffage (2) alimenté électriquement.

3. Procédé de mesure selon l'une des revendications 1 et 2, **caractérisé en ce qu'**après avoir mémorisé les paramètres électroniques à la seconde température (T2), le procédé comprend encore les étapes de :

   - régler la température localement dans le circuit intégré (1) au moyen de l'élément de chauffage (2) alimenté électriquement, jusqu'à une troisième température stable (T3) différente des première et seconde températures stables (T1, T2) du circuit intégré, en mesurant la troisième température au moyen du capteur de température (3, 3'),
   - effectuer des mesures des paramètres électroniques de l'ensemble électronique (4) à la troisième température stable, et mémoriser les paramètres électroniques à la troisième température stable (T3),
   - déterminer la variation en température des paramètres électroniques sur la base des paramètres mémorisés à la première température, à la seconde température et à la troisième température, afin d'effectuer une calibration de ces paramètres en fonction de paramètres de référence ou d'un comportement thermique attendu, et mémoriser les paramètres adaptés dans le circuit électronique intégré.

4. Procédé de mesure selon l'une des revendications précédentes, **caractérisé en ce que** le réglage de la première température (T1) ou de la seconde température (T2) ou de la troisième température (T3) est effectué dans une boucle d'asservissement d'un système de mesure avec le circuit électronique (1), au moyen d'une première valeur de consigne (Vc) pour définir la première température, d'une seconde valeur de consigne (Vc) pour définir la seconde température et d'une troisième valeur de consigne (Vc) pour définir la troisième température, et sur la base d'une mesure d'un premier capteur de température (3) à la première température ou à la seconde température ou à la troisième température.

5. Procédé de mesure selon la revendication 4, pour lequel il est prévu un second capteur de température (3'), le premier capteur de température (3) et le second capteur de température (3') étant une première jonction bipolaire (3) et une seconde jonction bipolaire (3'), qui sont intégrées dans le substrat semi-conducteur du circuit intégré, sous la forme d'une diode bipolaire ou d'un transistor bipolaire monté en diode, les première (3) et seconde (3') jonctions bipolaires étant reliées chacune à des plages de contact (5) correspondantes du circuit électronique intégré, où la première jonction bipolaire (3) est adaptée pour recevoir un courant (Im) d'adaptation d'une source de courant d'adaptation (12) pour définir une tension de jonction à comparer à chaque valeur de consigne pour adapter la température, et la seconde jonction bipolaire (3') est adaptée pour recevoir un courant d'une première source de courant (14) ou d'une seconde source de courant (15) et pour mesurer la tension de jonction en fonction du courant (I1, I2) traversant la seconde jonction bipolaire (3'), **caractérisé en ce que** pour déterminer chaque température mesurée par la seconde jonction bipolaire (3'), la seconde jonction bipolaire est traversée successivement par le premier courant continu (I1) de la première source de courant (14) et par le second courant continu (I2) de la seconde source de courant (15) de valeur différente du premier courant, et **en ce qu'**un écart de tension de jonction est mesuré sur la base des deux courants (I1, I2) fournis à la seconde jonction bipolaire (3') pour déterminer chaque température établie par l'élément de chauffage (2) alimenté électriquement.

6. Procédé selon la revendication 5, pour lequel la seconde jonction bipolaire (3') est adaptée pour recevoir un troisième courant (I3) d'une troisième source de courant (16), **caractérisé en ce que** la seconde jonction bipolaire (3') est traversée successivement par un premier courant (I1) de la première source de courant (14), par un second courant (I2) de la seconde source de courant (15) et par un troisième courant (I3) de la troisième source de courant (16), qui est différent des premier et second courants, et **en ce que** deux écarts de tension de jonction sont mesurés sur la base des trois courants (I1, I2, I3) pour déterminer la température établie par l'élément de chauffage (2) alimenté électriquement.

7. Procédé selon la revendication 4, pour lequel le capteur de température (3) est une jonction bipolaire (3) intégrée dans le substrat semi-conducteur du circuit intégré, sous la forme d'une diode bipolaire ou d'un transistor bipolaire monté en diode, la jonction bipolaire (3) étant reliée à des plages de contact (5) correspondantes du circuit électronique intégré, **caractérisé en ce que** la jonction bipolaire (3) est adaptée pour recevoir successivement un premier courant continu (I1) d'une première source de courant (14), un second courant continu (I2) d'une seconde source de courant (15) et un troisième courant continu (I3) d'une troisième source de courant (16), les trois courants continus étant de valeur différente, **en ce qu'**une mesure de chaque tension de jonction en fonction du courant (I1, I2, I3) traversant la jonction bipolaire (3) est effectuée et convertie successivement par un convertisseur analogique-numérique (17) pour être traitée dans une unité de traitement logique (18), afin de fournir un signal numérique de commande à un convertisseur numérique-analogique (19) relié à l'élément de chauffage (2) sur la base d'une valeur de consigne, et **en ce que** deux écarts de tension de jonction peuvent ainsi être déterminés dans l'unité de traitement logique (18) sur la base des trois courants (I1, I2, I3) ayant traversé successivement la jonction bipolaire (3) pour déterminer la température établie par l'élément de chauffage (2) alimenté électriquement.

8. Procédé de mesure selon l'une des revendications précédentes, pour lequel l'élément de chauffage (2) est une résistance diffusée ou implantée dans le substrat semi-conducteur du circuit intégré ou une résistance en poly-silicium, la résistance étant reliée à deux plages de contact (5) du circuit intégré (1), afin de recevoir un courant externe dépendant d'une valeur de consigne fonction de la température à établir localement dans le circuit intégré, le courant traversant la résistance de chauffage, étant adapté dans une boucle d'asservissement de courant, **caractérisé en ce que**, pour effectuer les mesures des paramètres électroniques, les première, seconde et troisième températures sont établies successivement par des premier, second et troisième courants traversant la résistance de chauffage, avec la première température inférieure à la seconde température, et la seconde température inférieure à la troisième température.

9. Procédé de mesure selon la revendication 4, pour lequel le système de mesure avec le circuit électronique (1) comprend dans la boucle d'asservissement de courant, un comparateur (11) externe pour comparer une tension de consigne (Vc) avec une tension de jonction ($V_{BE}$) d'une première jonction bipolaire intégrée (3), qui constitue le premier capteur de température (3), traversée par au moins un courant continu (Im) fourni par une source de courant d'adaptation (12) externe, la tension de consigne dépendant de la température à établir localement dans le circuit intégré par l'élément de chauffage (2), **caractérisé en ce qu'**en fixant une tension de consigne déterminée pour établir la première température, la seconde température ou la troisième température de mesure, une adaptation de la valeur du courant traversant une résistance de chauffage (2) en tant qu'élément de chauffage est effectuée par comparaison de la tension de jonction et de la tension de consigne.

10. Système de mesure pour la mise en oeuvre du procédé de mesure pour la calibration thermique d'un circuit électronique intégré (1) selon l'une des revendications précédentes, le circuit électronique intégré (1) comprenant au moins un élément de chauffage (2) disposé dans ou sur un substrat semi-conducteur du circuit intégré, au moins un capteur de température (3, 3') disposé dans ou sur le substrat semi-conducteur du circuit intégré, et un ensemble électronique (4) à calibrer du circuit intégré, dont des paramètres électroniques sont susceptibles de varier avec la température, **caractérisé en ce que** le système de mesure comprend une boucle d'asservissement dans laquelle est disposée le circuit électronique intégré (1) à calibrer, l'élément de chauffage (2) du circuit électronique étant alimenté électriquement dans la boucle d'asservissement en tenant compte d'une valeur de consigne fonction de la température à établir localement dans le circuit intégré à calibrer et d'une mesure de température d'au moins un capteur de température (3, 3').

11. Système de mesure selon la revendication 10, **caractérisé en ce que** l'élément de chauffage (2) du circuit électronique intégré (1) est une résistance diffusée ou implantée dans le substrat semi-conducteur du circuit intégré ou une résistance en poly-silicium, la résistance étant reliée à deux plages de contact (5) du circuit intégré (1), afin de recevoir un courant externe dépendant de la valeur de la consigne (Vc) fonction de la température à établir localement dans le circuit intégré, et **en ce que** le capteur de température (3) est une première jonction bipolaire sous la forme d'une diode bipolaire ou d'un transistor bipolaire monté en diode, la première jonction bipolaire (3) étant reliée à deux plages de contact (5) du circuit électronique intégré pour recevoir un courant d'une source de courant d'adaptation (12) externe et pour mesurer la tension de jonction en fonction du courant (Im) traversant la première jonction bipolaire.

12. Système de mesure selon la revendication 11, **caractérisé en ce que** la boucle d'asservissement de courant comprend un comparateur (11) pour comparer une tension de consigne (Vc) fonction de la température à établir localement dans le circuit intégré au moyen de la résistance de chauffage (2), et une tension de jonction ($V_{BE}$) de la première jonction bipolaire (3) traversée par le courant continu (Im) de la source de courant (12) externe, et **en ce que** la boucle d'asservissement de courant comprend encore un transistor bipolaire externe (P1), dont une base est commandée par une sortie du comparateur (11), et dont un émetteur et un collecteur sont reliés d'une part à une borne d'une source d'une tension d'alimentation, et d'autre part à une borne de la résistance de chauffage (2), afin de fournir un courant adapté à la résistance de chauffage suite à la comparaison de la tension de consigne et de la tension de jonction dans le comparateur (11).

13. Système de mesure selon la revendication 12, **caractérisé en ce que** le circuit électronique (1) comprend un second capteur de température (3'), qui est une seconde jonction bipolaire (3') reliée à deux plages de contact (5) du circuit électronique, ladite seconde jonction bipolaire (3') étant adaptée à recevoir successivement un premier courant continu (I1) d'une première source de courant (14), un second courant continu (I2) d'une seconde source de courant (15) et un troisième courant continu (I3) d'une troisième source de courant (16) pour mesurer deux écarts de tension de jonction sur la base des trois courants (I1, I2, I3) de valeur différente, pour déterminer la température établie par l'élément de chauffage (2) alimenté électriquement.

14. Système de mesure selon la revendication 12, **caractérisé en ce que** le transistor bipolaire externe (P1) est un transistor bipolaire PNP, dont l'émetteur est relié à une borne de potentiel haut de la source de tension d'alimentation, et le collecteur est relié à une première borne de la résistance de chauffage (2) par l'intermédiaire d'une première plage de contact (5) du circuit intégré, une seconde borne de la résistance de chauffage (2) étant reliée par l'intermédiaire d'une seconde plage de contact (5) du circuit intégré à une borne de potentiel bas de la source de tension d'alimentation.

15. Système de mesure selon la revendication 10, **caractérisé en ce que** la résistance de chauffage (2) du circuit électronique intégré (1) entoure un ensemble électronique (4) à calibrer, **en ce que** la jonction bipolaire (3) en tant que capteur de température est entourée par la résistance de chauffage, **en ce que** la jonction bipolaire (3) est reliée à deux plages de contact (5) du circuit électronique intégré pour recevoir successivement un premier courant continu (I1) d'une première source de courant (14), un second courant continu (I2) d'une seconde source de courant (15) et un troisième courant continu (I3) d'une troisième source de courant (16), et **en ce que** les tensions de jonction sur la base des trois courants de valeur différente, sont converties par un convertisseur analogique-numérique (17) pour être traitées dans une unité de traitement logique (18) afin de mesurer deux écarts de tension de jonction sur la base des trois courants (I1, I2, I3) pour déterminer la température établie par l'élément de chauffage (2) alimenté électriquement.

16. Circuit électronique intégré (1) convenant à la mise en oeuvre du procédé de mesure pour la calibration thermique du circuit électronique intégré (1) selon l'une des revendications 1 à 9, **caractérisé en ce qu'**il comprend au moins un élément de chauffage (2) disposé dans ou sur un substrat semi-conducteur du circuit intégré, au moins un capteur de température (3, 3') disposé dans ou sur le substrat semi-conducteur du circuit intégré, et un ensemble électronique (4) à calibrer du circuit intégré, dont des paramètres électroniques sont susceptibles de varier avec la température, et **en ce que** l'élément de chauffage, le capteur de température et certaines parties de l'ensemble électronique sont reliés à des plages métalliques de contact (5) pour pouvoir effectuer le procédé de mesure de paramètres électroniques à différentes températures.

17. Circuit électronique intégré (1) selon la revendication 16, **caractérisé en ce que** le capteur de température (3, 3') est une jonction bipolaire sous la forme d'une diode bipolaire ou d'un transistor bipolaire monté en diode, et **en ce que** l'élément de chauffage (2) est une résistance diffusée ou implantée dans le substrat semi-conducteur du circuit intégré ou une résistance en poly-silicium, la résistance étant configurée pour entourer l'ensemble électronique à calibrer.

18. Circuit électronique intégré (1) selon la revendication 17, **caractérisé en ce qu'**il comprend au moins deux capteurs de température (3, 3') disposés en des emplacements différents dans le circuit intégré, chaque capteur de température étant une jonction bipolaire reliée chacune à des plages de contact correspondantes (5) du circuit intégré, **en ce qu'**une première jonction bipolaire (3) est agencée pour adapter le courant dans la résistance de chauffage (2) dans une boucle d'asservissement d'un système de mesure, et **en ce que** la seconde jonction bipolaire (3') est agencée pour être traversée par deux ou trois courants continus (I1, I2, I3) successifs, afin de déterminer la température sur la base d'un ou deux écarts de tension mesurés avec les deux ou trois courants fournis à la seconde jonction bipolaire (3').

Fig. 1

Fig. 2

# Fig. 3

Europäisches
Patentamt

European
Patent Office

Office européen
des brevets

# RAPPORT DE RECHERCHE EUROPEENNE

Numéro de la demande

EP 12 15 1753

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2007/024379 A1 (GREENBERG JODY [US] ET AL) 1 février 2007 (2007-02-01) | 1,3,4, 8-12,14, 16 | INV.<br>H01L27/02<br>H01L23/34 |
| Y | * alinéa [0042] - alinéa [0066]; figures 2,3,4A,4B * | 5-7, 11-13, 15,17,18 | H03B5/04<br>H03L1/02 |
| X | US 2007/024292 A1 (GREENBERG J; JODY G; SEHAT S; SUTARDJA S) 1 février 2007 (2007-02-01) * alinéa [0038] - alinéa [0045]; figures 1-4,5A,5B * | 1,10,16 | ADD.<br>G01R31/28 |
| X | US 2004/071029 A1 (SUTACHA S; SUTARDJA S) 15 avril 2004 (2004-04-15) * alinéa [0029] - alinéa [0034]; figure 4 *<br><br>* alinéa [0051]; figure 10 * | 1,10,16 | |
| X | US 2011/121292 A1 (SAETHER TERJE [NO]) 26 mai 2011 (2011-05-26) * alinéa [0008] - alinéa [0011]; figures 1-3 * | 1,10,16 | DOMAINES TECHNIQUES RECHERCHES (IPC)<br>H01L<br>H03B |
| Y,D | US 5 195 827 A (AUDY JONATHAN M [US] ET AL) 23 mars 1993 (1993-03-23)<br><br>* colonne 3, ligne 40 - colonne 7, ligne 7; figure 4 * | 5-7, 11-13, 15,17,18 | H03L |
| A,D | US 4 284 872 A (GRAEME JERALD G) 18 août 1981 (1981-08-18) * colonne 6, ligne 43 - colonne 8, ligne 50; figure 5 * | 15,17 | |
| A | US 2011/102005 A1 (FENG KAI D [US] ET AL) 5 mai 2011 (2011-05-05) * alinéa [0014] - alinéa [0016]; figure 1 * | 15,17 | |

Le présent rapport a été établi pour toutes les revendications

| Lieu de la recherche | Date d'achèvement de la recherche | Examinateur |
|---|---|---|
| Munich | 6 juillet 2012 | Hijazi, Ali |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 12 15 1753

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-07-2012

| Document brevet cité au rapport de recherche | | Date de publication | Membre(s) de la famille de brevet(s) | | Date de publication |
|---|---|---|---|---|---|
| US 2007024379 | A1 | 01-02-2007 | US | 2007024379 A1 | 01-02-2007 |
| | | | US | 2008266034 A1 | 30-10-2008 |
| | | | US | 2011128062 A1 | 02-06-2011 |
| US 2007024292 | A1 | 01-02-2007 | US | 2007024292 A1 | 01-02-2007 |
| | | | US | 2008157798 A1 | 03-07-2008 |
| US 2004071029 | A1 | 15-04-2004 | CN | 1497835 A | 19-05-2004 |
| | | | EP | 1411630 A1 | 21-04-2004 |
| | | | JP | 2004201280 A | 15-07-2004 |
| | | | TW | I279072 B | 11-04-2007 |
| | | | US | 2004071029 A1 | 15-04-2004 |
| US 2011121292 | A1 | 26-05-2011 | AUCUN | | |
| US 5195827 | A | 23-03-1993 | AUCUN | | |
| US 4284872 | A | 18-08-1981 | AUCUN | | |
| US 2011102005 | A1 | 05-05-2011 | AUCUN | | |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5195827 A

- US 4284872 A